# EUROPEAN PATENT APPLICATION

(11) **EP 4 761 111 A1**
(43) Date of publication of application: **17.06.2026**
(21) Application number: 25217104.6
(22) Date of filing: 19.11.2025
(51) Int. Cl.: H03K 3/3562, H03K 5/08, H03K 5/24

(54) **A CONTINUOUS TIME COMPARATOR WITH IMPROVED PROPAGATION DELAY FOR A GIVEN CURRENT**

(30) Priority: 14.12.2024 IN 202411099048
(71) Applicant: Nexperia B.V., 6534 AB Nijmegen (NL)
(72) Inventor: Shaw, Rahul, Karnataka (IN); Bahirvani, Gaurav, Karnataka (IN)
(74) Representative: Pjanovic, Ilija

(57) **Abstract**

A continuous time comparator, comprising a first Field Effect Transistor, FET, (Mn1) arranged for receiving a first input signal, and a second **FET** (Mn2) arranged for receiving a second input signal, two branches, a first of said two branches comprises a first transistor (Mp1) and a second of said two branches comprises a second transistor (Mp2), wherein said first of said two branches is connected to said first **FET** (Mn1) and wherein said second of said two branches is connected to said second **FET** (Mn2), a first dynamic clamp circuitry connected in parallel over said first branch, wherein said first dynamic clamp circuitry is arranged to dynamically clamp a voltage at a gate of a first output transistor (Mp4), and a second dynamic clamp circuitry connected in parallel over said second branch, wherein said second dynamic clamp circuitry is arranged to dynamically clamp a voltage at a gate of a second output transistor (Mp3), said first and second output transistors (Mp3, Mp4) for providing an output of said comparator and for providing an inverting output of said comparator.

## Description

### Technical field

The present disclosure is directed to continuous time comparators and, more specifically, to a continuous time comparator having improved propagation delay for a given current.

### Background of the disclosure

Continuous-time comparators are circuits designed to compare two input voltages Va and Vb, and generate an output signal based on their difference. The comparator's output is high Vdd when Va-Vb>0, and low Vss when Va-Vb<0. These circuits are commonly used in various analog and mixed-signal applications for signal conditioning, threshold detection, and decision-making.

Comparators are categorized based on the type of input signals they process. Continuous-time comparators continuously operate on input signals, while dynamic comparators are designed for providing an output at discrete-time instances. The design of continuous-time comparators often includes features such as integrated symmetric hysteresis. This hysteresis enhances stability and helps ensure consistent operation by providing immunity to noise and small input fluctuations.

The performance of comparators is closely tied to propagation delays, which are the times taken for the output to transition in response to a change in the input. These delays include the low-to-high and high-to-low propagation delays. Delays may be asymmetric, with low-to high delays being lower than high-to-low. The fall time of the output signal may also be limited by slew rate, reflecting constraints due to the circuit's bias current.

Alternatively, the propagation delay, as well as the rise and fall times of the output, may be jointly limited by the bias current of the design. These factors influence the speed and efficiency of the comparator, highlighting the trade-offs in comparator designs aimed at achieving optimized performance under specific power and loading conditions.

### Summary

It would be advantageous to achieve a continuous time comparator having an improved propagation delay for a given current.

In a first aspect of the present disclosure, there is provided continuous time comparator, comprising:
- a first Field Effect Transistor, FET, (Mn1) arranged for receiving a first input signal, and a second FET (Mn2) arranged for receiving a second input signal;
- two branches, a first of said two branches comprises a first transistor (Mp1) and a second of said two branches comprises a second transistor (Mp2), wherein said first of said two branches is connected to said first FET (Mn1) and wherein said second of said two branches is connected to said second FET (Mn2);
- a first dynamic clamp circuitry connected in parallel over said first branch, wherein said first dynamic clamp circuitry is arranged to dynamically clamp a voltage at a gate of a first output transistor (Mp4), and a second dynamic clamp circuitry connected in parallel over said second branch, wherein said second dynamic clamp circuitry is arranged to dynamically clamp a voltage at a gate of a second output transistor (Mp3),
- said first and second output transistors (Mp3, Mp4) for providing an output of said comparator and for providing an inverting output of said comparator.

Here below, a typical example of a continuous time comparator in accordance with the present disclosure is provided.

A continuous-time comparator is a component in various analog and mixed-signal circuits, commonly used for applications such as analog-to-digital converters, ADCs, signal detection, and threshold comparison. The described design introduces a configuration aimed at improving the performance and speed of a continuous-time comparator. This configuration is detailed as follows.

The comparator comprises several elements, starting with two Field Effect Transistors, FETs. The first FET, denoted as Mn1, is configured to receive a first input signal, while the second FET, referred to as Mn2, is designed to handle a second input signal. These input transistors form the input stage of the comparator, where the signals to be compared are introduced.

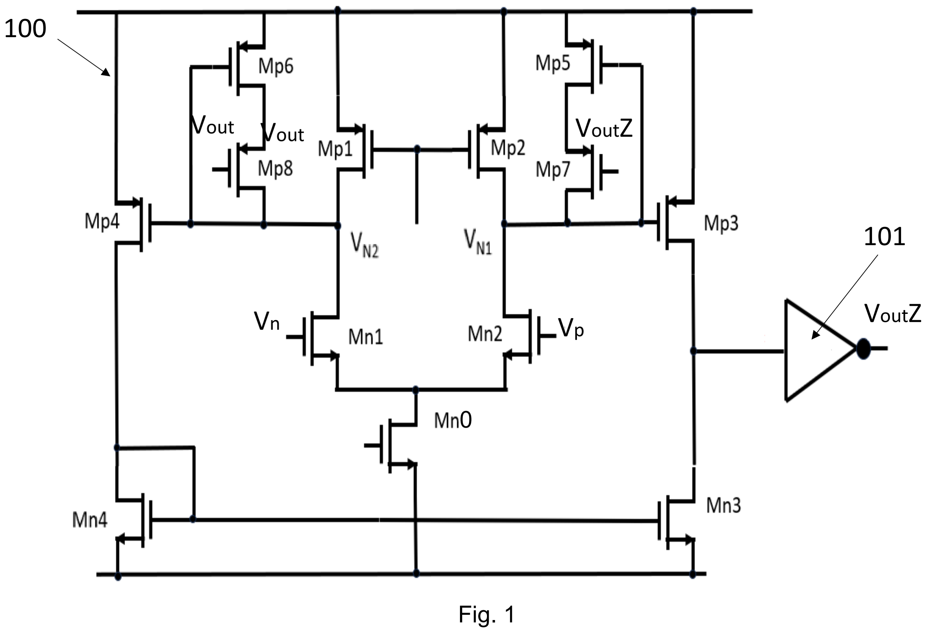

The design incorporates two branches that connect the input FETs to subsequent circuit elements. Each branch includes a transistor to manage signal flow and establish the circuit's operation. The first branch features a transistor labeled Mp1 (figure 1), and the second branch includes a transistor identified as Mp2. The first branch is connected to the first FET (Mn1), while the second branch is connected to the second FET (Mn2).

The design employs dynamic clamping circuitry in both branches. In the first branch, a first dynamic clamp circuitry is connected in parallel, serving to dynamically regulate the voltage at the gate of the first output transistor (Mp4). Similarly, the second branch is equipped with a second dynamic clamp circuitry, which dynamically clamps the voltage at the gate of the second output transistor (Mp3). These dynamic clamp circuits play a role in improving the propagation delay of the comparator by limiting, or reducing, voltage swings and improving response times.

The final stage of the comparator includes the output transistors Mp3 and Mp4, which provide the comparator's outputs. Specifically, the transistor Mp3 generates the inverting output, while Mp4 provides the non-inverting output. These outputs are used to indicate the result of the comparison, effectively showing whether the first input signal is greater or smaller than the second input signal.

This design presents several advantages over traditional comparator configurations. The use of dynamic clamping circuitry improves the comparator's ability to handle high-speed and continuous-time operations. By dynamically regulating the gate voltages of the output transistors, the circuit minimizes delay. Additionally, the symmetrical arrangement of the branches ensures balanced performance, reducing offset errors and providing accurate comparison results.

A typical example of such a comparator might involve comparing analog signals in high-frequency environments, such as those found in communication systems or sensor applications. The dynamic nature of the clamping circuitry allows for rapid transitions between states, making the comparator suitable for applications requiring high-speed and low-latency decision-making.

In summary, this continuous-time comparator design leverages a thoughtful arrangement of input FETs, branching transistors, and dynamic clamping circuitry to deliver robust performance. Its ability to handle continuous and high-speed input signals while maintaining precision makes it an invaluable component in modern electronic systems.

A comparator circuit may thus operate using multiple MOSFETs arranged to provide differential signal comparison and output generation. At its core, the circuit may utilize a pair of MOSFETs as a differential input stage, which compares an input signal against a reference voltage, or two input signals. These input MOSFETs may share a current source that supplies a bias current, splitting it between the two input transistors based on the voltage difference between the input and reference signals.

The inventors have found that it may be beneficial to introduce dynamic clamping circuitry to dynamically clamp a voltage at the gates of the output transistors. Dynamically clamping entails that the voltage at these gates is steered towards a voltage closer to the transition voltage of the comparator. This is now referred to the dynamic voltage. The voltage at the gates of the output transistors may, for example, temporarily exceed such a dynamic voltage but is then steered, or directed, to this dynamic voltage. The advantage hereof is that the propagation delay is reduced as the voltage at the gates of the output transistors are pre-set to close to the transition voltage.

In an example, the continuous time comparator further comprises a cross-coupled first and second bias transistors (Mn3, Mn4) connected in series with said first and second output transistors (Mp3, Mp4).

In another example, the first transistor (Mp1) of said first branch and said second transistor (Mp2) of said second branch are cross-coupled.

The combination of the cross-coupling of these transistors with the dynamically clamping circuitry enables the in-built hysteresis of the continuous time comparator.

In a further example, each of said first dynamic clamp circuitry and said second dynamic clamp circuitry comprises:
- a clamping transistor (Mp5, Mp6) connected in series with a clamp control transistor (Mp8, Mp7).

The inventors have found that a beneficial implementation of a dynamic clamping circuit may be obtained by using two transistors connected in series. A so-called clamping transistor in combination with the clamp control transistor. The clamp control circuit ensures that the clamping is performed during particular outputs.

In a further example, the clamp control transistors (Mp7, Mp8) of said first clamp circuitry and said second clamp circuitry are connected to said output of said comparator and said inverting output of said comparator.

As such, the gate terminals of these clamp control transistors may be connected to the (inverted) output of the comparator.

In another example, the comparator further comprises:
- a first swing reduction circuit connected in series with said first bias transistor (Mn3), wherein said first swing reduction circuit is arranged to include an impedance in series with said first bias transistor (Mn3) based on a low output of said comparator;
- a second swing reduction circuit connected in series with said second bias transistor (Mn4), wherein said second swing reduction circuit is arranged to include an impedance in series with said second bias transistor (Mn4) based on a high output of said comparator.

In yet another example, the first and/or said second swing reduction circuit comprises said corresponding impedance connected in parallel with a switch, wherein said switch is controlled based on a corresponding low and high output of said comparator.

The benefit of introducing such a resistance is that the swing at the gates of the output transistors is reduced.

In another example, the comparator is implemented on a semiconductor die.

In a second aspect of the present disclosure, there is provided an integrated circuit, IC, comprising a continuous time comparator in accordance with any of the previous examples.

It is noted that the advantages as explained with reference to the first aspect of the present disclosure, being the continuous time comparator, are also applicable to the second aspect of the present disclosure, being the Integrated Circuit, IC.

In a third aspect of the present disclosure, there is provided a method of controlling the continuous time comparator, the method comprises the steps of:
- dynamically clamping, by said first dynamic clamp circuitry, said voltage at said gate of said first output transistor, and
- dynamically clamping, by said second dynamic clamp circuitry, said voltage at said gate of said second output transistor.

It is noted that the advantages as explained with reference to the first aspect of the present disclosure, being the continuous time comparator, are also applicable to the third aspect of the present disclosure, being the method of operating the continuous time comparator.

In an example, the comparator comprises cross-coupled bias transistors (Mn3, Mn4) connected in series with said first and second output transistors (Mp3, Mp4)

In another example, the first transistor (Mp1) of said first branch and said second transistor (Mp2) of said second branch are cross-coupled.

In yet another example, each of said first dynamic clamp circuitry and said second dynamic clamp circuitry comprises:
- a clamping transistor (Mp5, Mp6) connected in series with a clamp control transistor (Mp8, Mp7).

In yet another example, the clamp control transistors (Mp7, Mp8) of said first clamp circuitry and said second clamp circuitry are connected to said output of said comparator and said inverting output of said comparator.

In yet another example, the comparator further comprises:
- a first swing reduction circuit connected in series with said first bias transistor (Mn3), wherein said first swing reduction circuit is arranged to include an impedance in series with said first bias transistor (Mn3) based on a low output of said comparator;
- a second swing reduction circuit connected in series with said second bias transistor (Mn4), wherein said second swing reduction circuit is arranged to include an impedance in series with said second bias transistor (Mn4) based on a high output of said comparator.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the drawings

The disclosure will now be discussed with reference to the drawings, which show in:
Figure 1 depicts an example of a continuous time comparator in accordance with the present disclosure;
Figure 2 depicts another example of a continuous time comparator in accordance with the present disclosure;
Figure 3 depicts yet another example of a continuous time comparator in accordance with the present disclosure;
Figure 4 discloses specific waveforms corresponding to the continuous time comparator in accordance with the present disclosure.

### Detailed description of the disclosure

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof.

Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

Reference is now made to the continuous time comparator shown in figures 1 - 3.

The architecture is symmetrical, ensuring that performance parameters such as propagation delay, rise and fall times, and hysteresis are balanced and consistent across the circuit. This symmetry simplifies the design process and enhances the predictability of the comparator's behavior under various operating conditions.

The in-built hysteresis is improved to provide an improved propagation delay. The hysteresis is achieved using a combination of dynamic clamp circuitry and a cross-coupled load in the first stage. The ratios of the transistors in this configuration, such as Mp1:Mp5:Mp3 and Mp2:Mp6:Mp4, are typically set to 2:1:N, where "N" depends on the required level of hysteresis. The incorporation of positive feedback in this stage introduces and sustains the hysteresis. This positive feedback amplifies the difference between the two input signals, making the circuit more robust against small, unwanted fluctuations caused by noise.

It is noted that the transistor Mn0 may be added to provide a (current) bias to the input stage.

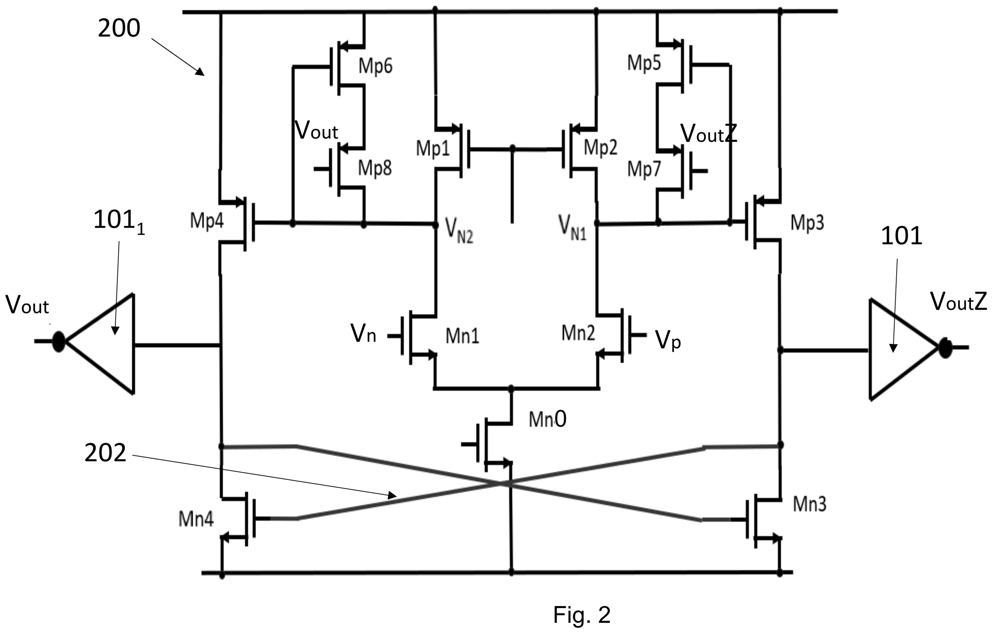

In the output stage, the architecture may employ a digital-level shifter-like structure with cross-coupled NMOS transistors (figure 2). This design converts the output stage into a digital circuit that operates without static current, effectively reducing the quiescent current, IQ, of the comparator.

The absence of static current enhances power efficiency, which is a often an important factor in low-power applications. Moreover, this configuration reduces the slew rate limitations at the output stage, ensuring faster transitions and improving overall performance.

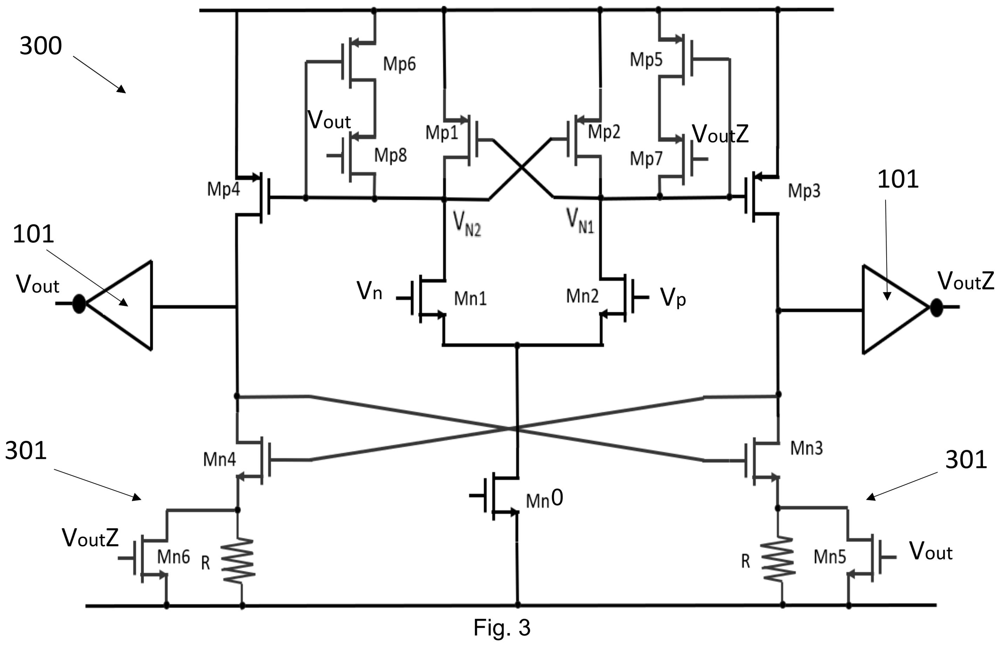

Propagation delay is further reduced by reducing the voltage swing required at the internal nodes Vn1 and Vn2 (figure 3). This is achieved through resistor degeneration, which modulates the strength of the NMOS transistors based on the output transition. During a low-to-high transition of the output of the comparator, i.e. Vout, Mn4 is turned off (0V), which weakens Mn3, thereby reducing the voltage swing and improving response time.

Conversely, during a high-to-low transition, Mn4 is turned on (Vdd), strengthening Mn3 and ensuring a fast transition. This adaptive approach to controlling transistor strength optimizes the circuit's speed without compromising stability.

Overall, the design represents a significant improvement in comparator performance, offering symmetrical operation, low power consumption, and reduced propagation delay. The inclusion of dynamic clamping, positive feedback, and adaptive transistor modulation makes it highly suitable for high-speed, low-power applications where precision and efficiency are paramount.

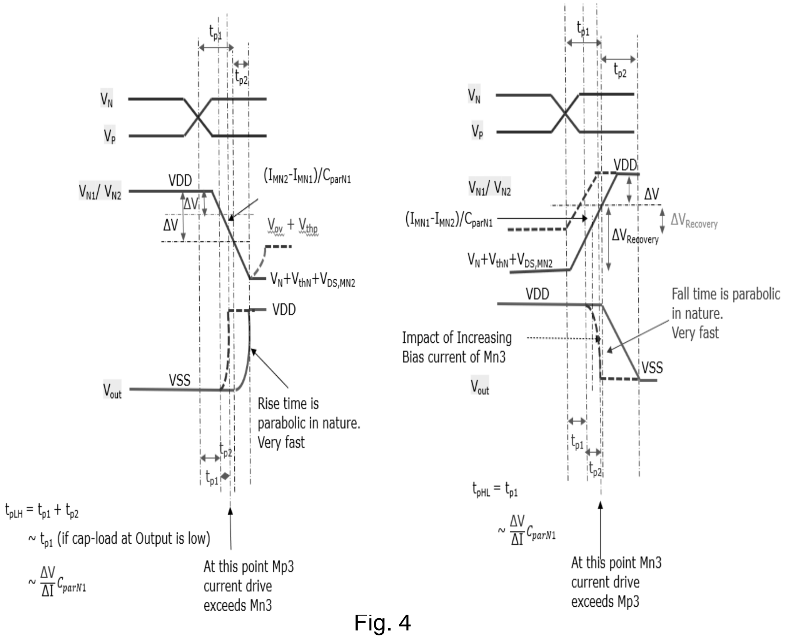

Figure 4 is a typical example of the waveforms at certain nodes in the continuous time comparator. The dynamic clamping circuit is visualized by the voltage at the gates of the output capacitor being directed to "V₀ᵥ + Vₜₕₚ".

It is noted that figure 4 discloses waveforms having a solid line and a dashed line. The dashed lines are the waveforms in accordance with the present disclosure.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

## Claims

1. A continuous time comparator, comprising:
- a first Field Effect Transistor, FET, (Mn1) arranged for receiving a first input signal, and a second FET (Mn2) arranged for receiving a second input signal;
- two branches, a first of said two branches comprises a first transistor (Mp1) and a second of said two branches comprises a second transistor (Mp2), wherein said first of said two branches is connected to said first FET (Mn1) and wherein said second of said two branches is connected to said second FET (Mn2);
- a first dynamic clamp circuitry connected in parallel over said first branch, wherein said first dynamic clamp circuitry is arranged to dynamically clamp a voltage at a gate of a first output transistor (Mp4), and a second dynamic clamp circuitry connected in parallel over said second branch, wherein said second dynamic clamp circuitry is arranged to dynamically clamp a voltage at a gate of a second output transistor (Mp3),
- said first and second output transistors (Mp3, Mp4) for providing an output of said comparator and for providing an inverting output of said comparator.

2. A continuous time comparator in accordance with claim 1, wherein said continuous time comparator further comprises a cross-coupled first and second bias transistors (Mn3, Mn4) connected in series with said first and second output transistors (Mp3, Mp4).

3. A continuous time comparator in accordance with any of the previous claims, wherein said first transistor (Mp1) of said first branch and said second transistor (Mp2) of said second branch are cross-coupled.

4. A continuous time comparator in accordance with any of the previous claims, wherein each of said first dynamic clamp circuitry and said second dynamic clamp circuitry comprises:
- a clamping transistor (Mp5, Mp6) connected in series with a clamp control transistor (Mp8, Mp7).

5. A continuous time comparator in accordance with claim 3, wherein said clamp control transistors (Mp7, Mp8) of said first clamp circuitry and said second clamp circuitry are connected to said output of said comparator and said inverting output of said comparator.

6. A continuous time comparator in accordance with claim 2, wherein said comparator further comprises:
- a first swing reduction circuit connected in series with said first bias transistor (Mn3), wherein said first swing reduction circuit is arranged to include an impedance in series with said first bias transistor (Mn3) based on a low output of said comparator;
- a second swing reduction circuit connected in series with said second bias transistor (Mn4), wherein said second swing reduction circuit is arranged to include an impedance in series with said second bias transistor (Mn4) based on a high output of said comparator.

7. A continuous time comparator in accordance with claim 6, wherein said first and/or said second swing reduction circuit comprises said corresponding impedance connected in parallel with a switch, wherein said switch is controlled based on a corresponding low and high output of said comparator.

8. A continuous time comparator in accordance with any of the previous claims, wherein said comparator is implemented on a semiconductor die.

9. An integrated circuit, IC, comprising a continuous time comparator in accordance with any of the previous claims.

10. A method of operating a continuous time comparator in accordance with any of the claims 1 - 8, wherein the method comprises the steps of:
- dynamically clamping, by said first dynamic clamp circuitry, said voltage at said gate of said first output transistor, and
- dynamically clamping, by said second dynamic clamp circuitry, said voltage at said gate of said second output transistor.

11. A method in accordance with claim 10, wherein said comparator comprises cross-coupled bias transistors (Mn3, Mn4) connected in series with said first and second output transistors (Mp3, Mp4)

12. A method in accordance with any of the claims 10 - 11, wherein said first transistor (Mp1) of said first branch and said second transistor (Mp2) of said second branch are cross-coupled.

13. A method in accordance with any of the claims 10 - 12, wherein each of said first dynamic clamp circuitry and said second dynamic clamp circuitry comprises:
- a clamping transistor (Mp5, Mp6) connected in series with a clamp control transistor (Mp8, Mp7).

14. A method in accordance with any of the claims 10 - 13, wherein said clamp control transistors (Mp7, Mp8) of said first clamp circuitry and said second clamp circuitry are connected to said output of said comparator and said inverting output of said comparator.

15. A method in accordance with any of the claims 10 - 14, wherein said comparator further comprises:
- a first swing reduction circuit connected in series with said first bias transistor (Mn3), wherein said first swing reduction circuit is arranged to include an impedance in series with said first bias transistor (Mn3) based on a low output of said comparator;
- a second swing reduction circuit connected in series with said second bias transistor (Mn4), wherein said second swing reduction circuit is arranged to include an impedance in series with said second bias transistor (Mn4) based on a high output of said comparator.
